Europäisches Patentamt

European Patent Office

Office européen des brevets

(11) Publication number: **0 213 044**
A2

# (12) EUROPEAN PATENT APPLICATION

(21) Application number: 86401808.0

(22) Date of filing: 13.08.86

(51) Int. Cl.⁴: **G 06 F 11/20**

(30) Priority: 20.08.85 US 767404

(43) Date of publication of application: 04.03.87
Bulletin 87/10

(84) Designated Contracting States: AT DE FR GB IT NL

(71) Applicant: THOMSON COMPONENTS-MOSTEK
CORPORATION, 1310 Electronics Drive, Carrollton
Texas 75006 (US)

(72) Inventor: Johnson, Mark C., THOMSON-CSF SCPI 19,
avenue de Messine, F-75008 Paris (FR)
Inventor: Taylor, Ronald T., THOMSON-CSF SCPI 19,
avenue de Messine, F-75008 Paris (FR)

(74) Representative: Guérin, Michel et al, THOMSON-CSF
SCPI 19, avenue de Messine, F-75008 Paris (FR)

(54) **Defective element disabling circuit having a laser-blown fuse.**

(57) A decoder circuit for disabling a defective element in
a circuit having redundant replacement elements employs a
fuse on a signal path through the decoder circuit from
a selection device to a low-impedance output device and a
weak default circuit, such as a pull-up transistor, for forcing
the state of the output circuit to a low-impedance default state
when the fuse is blown.

Description

Defective Element Disabling Circuit
Having a Laser-Blown Fuse

Technical Field

The field of the invention is that of integrated circuits having redundant elements, in particular memory cirucits having redundant rows or columns.

Background Art

The use of redundant rows or columns of elements in integrated circuit memories is well known in the art. A conventional method of implementing such redundancy is shown in an article by K. Kokkonen, P. O. Sharp, R. Albers, J. P. Dishaw, F. Louie and R. J. Smith titled "Redundancy Techniques for Fast Static Rams", Digest of Technical Papers, IEEE 1981 International Solid State Circuits Conference, pages 80-81. In this conventional approach a redundant activation circuit recognizes the address of a defective element, through laser programming or an equivalent method, and sends a disable signal ("NED") that electrically disables the decoders of all the regular elements in the memory array. The defective element is thus disabled, as well as all the other elements. The spare row or column that was programmed to recognize that particular address is then free to generate its output signal. The advantange of this method is that only one decoder needs to be programmed for each defect — the decoder on the spare row or column. There is no need to program the defective row or column to disable it

- 2 -

because all rows or columns are electrically disabled. A well known disadvantage of this method is that the disable signal (NED) must drive a large capacitance since it is connected to all of the rows and columns, not just to a defective one. There is thus a larger or longer response time for repaired elements than there is for normal elements and the specification of the circuit must be altered to allow for this extra response time.

Another prior art circuit, shown in a paper by Smith, Bateman, Sharp, Dishaw and Smudski, FAM 18.3, ISSCC 1982, pages 252, 253, teaches away from the invention in that it teaches the use of a NED approach for rows together with a column-disabling system for disabling only one out of a set of eight selected columns that employs an extremely large pull-down resistor, having a value of 1000 megohms, in a series connection with a fuse connected to the gate of a column pass transistor.

Disclosure of Invention

The invention relates to a decoder circuit for disabling a defective element in a circuit where there are redundant elements available. The decoder scheme employs a fuse on a signal path through the decoder and a default circuit for controlling the output state of the decoder when the signal path is in a high impedance state, such as when a laser-blown fuse is open.

A feature of the invention is the suppression of noise coupled into the circuit by the provision of a low-impedance path from the enabling line to either ground or VCC.

Brief Description of Drawings

Figure 1 illustrates a prior art method of controlling redundant elements.

Figure 2 illustrates another prior art method.

Figure 3 illustrates an embodiment of the invention.

Figure 4a-4c illustrate alternative embodiments of the invention.

Best Mode of Carrying Out the Invention

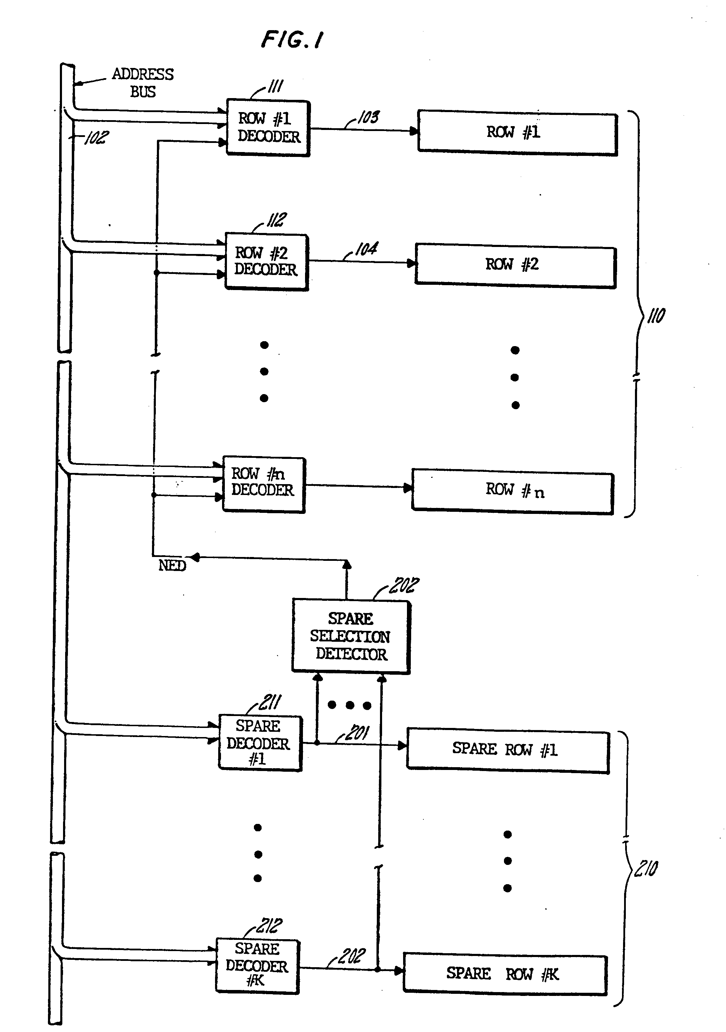

In Figure 1, a prior art embodiment referred to above is illustrated, in which a memory array indicated by the bracket labeled 110 and a redundant set of rows indicated by the bracket labeled 210 are both connected to a set of decoders and thus to a common address bus 102. The address bus transmits addresses to a set of conventional decoders, indicated by 111 and 112 in the figure, and spare decoders indicated by the numerals 211 and 212. Each decoder, which is conventional in the art, will respond to its particular address by activating an output line that will enable the row or column to which it is connected. When one row is defective, that row must be disabled and one of the spare rows must be enabled to respond to the correct address. Spare selection detector circuit 202 in the figure has the form illustrated in the above reference and responds to any activation signal from a spare decoder on one of lines 201 or 202 in the drawing to generate a normal element disable signal, referred to as NED, that disables all of the decoders in the regular array. The disadvantage of this approach, as was discussed above, is that circuit 202 must drive a large capacitive load because of the many elements that are connected to it, and thus the response of the memory in the case of a defective row takes a longer time than it does for the response to a normal row.

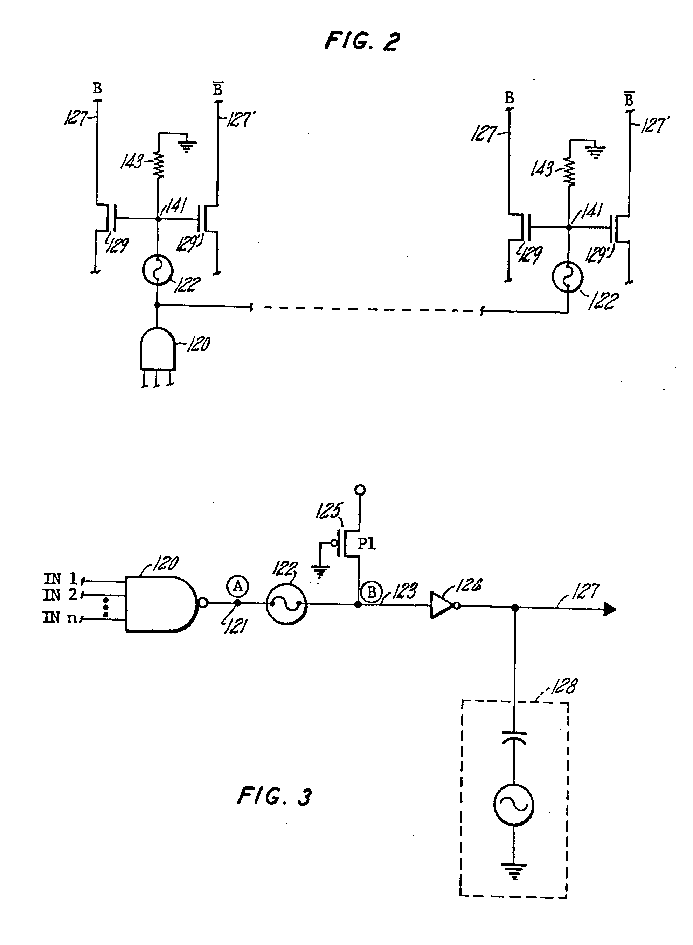

Figure 2 shows a portion of another prior art circuit that is used in the particular case of a by-8 memory in which a single column select signal enables a column in each of eight blocks. Only two blocks are shown in the drawing for simplicity. When only one column is defective, it is necessary to disable only one column out of the eight selected columns in order to use the remaining seven columns. This is accomplished by the circuit shown, in which a decoder (120) output is connected directly to eight fuses 122, each of which is in series with the gates of a pair of pass transistors 129 and 129' that are connected to BIT and $\overline{BIT}$ lines 127 and 127'. The (single) fuse connected to the defective column will be blown. Note that the fuse is not series-connected to the column or row enable line, but only to two transistor gates. Because the decoder must be on pitch with two lines in this case, it must be physically small, and thus can pass only a relatively small amount of current. The single RC time constant resulting from the non-trivial resistance of the fuse and the gate capacitance of the relatively large pass transistors degrades the switching time for this arrangement. Another drawback of this circuit is that the extremely high impedance of the 1000 megohm path to ground through resistor 143 makes this circuit susceptible to noise that is inevitably coupled in to node 141 between the pass transistor gate and the fuse.

Referring now to Figure 3, there is illustrated an embodiment of the invention in which one conventional row decoder, indicated by numeral 120, and having the form of a conventional NAND gate with an output node 121 responds to an address on the address bus. The signal path in this case is from decoder 120 through fuse 122 to node 123 then through inverter 126 to output node 127. The decoder circuit is the set of elements 120 through 126. Other elements in the circuit are a conventional P-Channel pull up transistor 125 and an element 128 which represents noise coupled into node 127 by associated elements inside or outside of the circuit. The magnitude of transistor 125 is selected so that it is a weak transistor having a relatively small current capacity (say 2 microamperes). Thus, in normal operation, the state of node 123 will be determined by the state of node 121, the output of NAND gate 120 and transistor 125 will have essentially no effect on the operation of the circuit. In order for this to be accomplished of course, as is well known, the current carrying capacity of the path through circuit 120 to ground must dominate the effect of transistor 125. Those skilled in the art will readily be able to devise transistors having appropriate parameters to achieve this conventional result. In a particular example, the current capacity is 2 milliamperes.

If there is a defective element in the row controlled by node 127, then fuse 122 will be blown by a laser, for example, or by the application of a large electrical current or any other conventional means. Decoder 120 is thus effectively isolated from node 123 and pull up transistor 125 brings node 123 to a permanent voltage level of VCC. That, in turn, causes inverter 126 to put node 127 in the conventional logic 0 state to disable the row to which it is attached. An advantage of this method is that inverter 126 has two low impedance states that are a relatively low-impedance path to either VCC or ground, so that any noise coming from box 128 and coupling to this row line will be suppressed by the action of the transistors within inverter 126 and the row controlled by node 127 will not be enabled or disabled by noise, even momentarily.

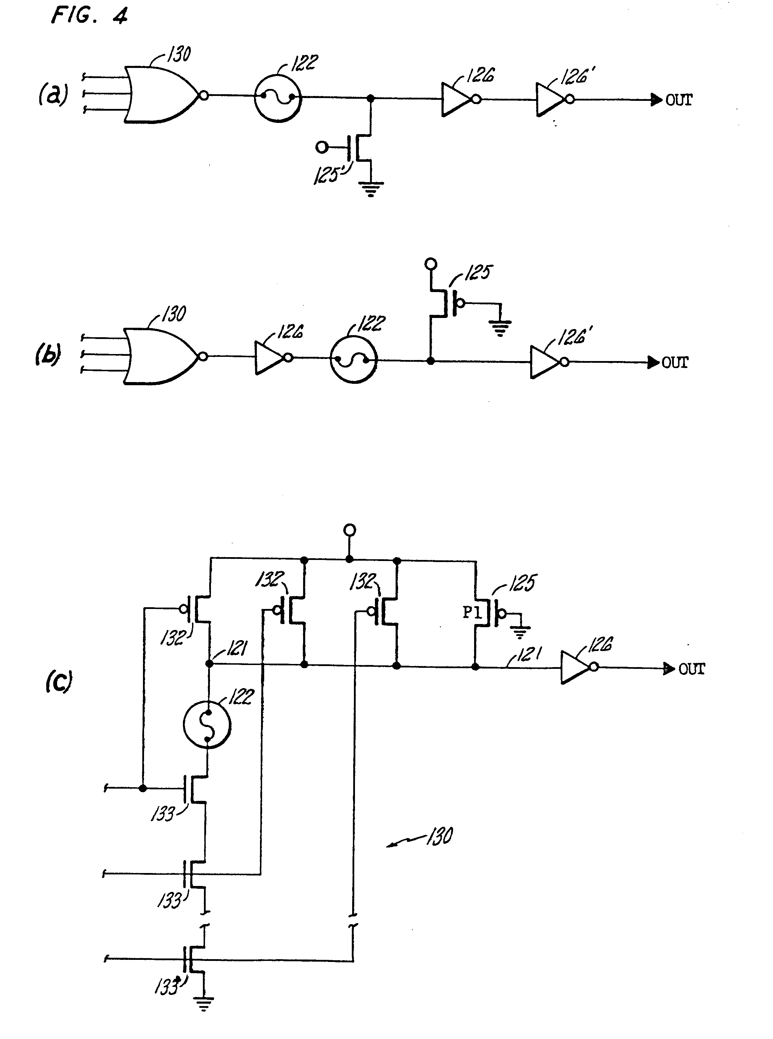

Referring now to Figures 4a and 4b, there is shown a pair of alternative embodiments that employ NOR gates 130 instead of NAND gate 120 of Figure 2. In Figure 4a, a pull down transistor is used together with an extra inverter 126' to compensate for the effect of the NOR gate instead of the NAND gate. In Figure 4b, two inverters are also used, but the final stage is that of a pull up transistor after the fuse, followed by a single inverter. When the fuse is blown, the output stage is equivalent to that in Figure 3. When the fuse is not blown, then inverter 126 takes over the job of establishing the correct state and overriding the effect of transistor 125.

Referring now to Figure 4c, there is shown the interior of a NAND gate in which fuse 122 is now placed on the series path from ground through all of the N-Channel transistors 133 to output node 121. Fuse 122 performs the function of blocking the signal from the decoder by preventing the transition of node 121 that generates the high going OUT signal. For purposes of this application this effect will also be referred to as blocking the passage at the output signal.

The embodiment of Figure 3 was adapted to use with a decoder having active-high inputs and an output that is also active-high. Figure 4c is also adapted to the same conditions. Figures 4a and 4b are adapted to a situation in which the inputs are active-low and the output is active-high. Those skilled in the art will readily be able to modify this arrangement for any other desired combination of input and output states.

An important practical advantage of the invention is that it adds very little extra power dissipation in operation. A DC current path exists only when node 123, the input to inverter 126, is pulled low. This only happens in a decoder that is used in the regular array (a regular decoder). All regular decoders that are not active have their node 123 at the normal state of VCC so that no current is drawn through transistor 125. The extra power consumed by the application of this invention is merely the saturation current of one pull up transistor 125, independent of the total number of rows in the memory array or decoders used in other applications of the circuit.

Another advantage of the invention is that capacative coupling and cross talk will be supressed at the decoder output because the decoder output is always connected directly to an inverter. The undesirable prior art circuit of Figure 2 has a high impedance at the pass transistor gates which is susceptible to noise coupled onto node 127' from some other source.

With respect to the speed at which the circuit operates, the only effect is the slight additional time required to overcome transistor 125 when node 123 is to be driven low. Since transistor 125 is a small transistor, having a small capacitance, this effect is small compared to the delay in operating the conventional circuit illustrated in Figure 1.

Claims

1.    A random access memory comprising a memory matrix and control means therefor, said memory matrix having a plurality of rows, each row having a row address within a row address range and a row activation means connected thereto for applying a control signal to said row in response to a predetermined row address within said row address range;

at least two redundant row lines, each having a redundant row activation means connected thereto, for applying an activation signal to one of said at least two redundant row lines, each of said redundant row activation means comprising a programmable address-recognition means for responding to a programmed defective row address within said row address range that identifies a defective row in said memory matrix; and

means for inactivating at least that one of said plurality of rows having said defective row address, whereby an activated redundant row having an address-recognition means programmed to respond to a predetermined defective row address substitutes for a defective row having the same defective row address, characterized in that:

said means for inactivating at least one of said plurality of rows comprises a plurality of programmable inactivation means, each connected to a row activation means for long-term inactivation thereof, each programmable inactivation means being electrically independent of that one of said programmable address-recognition means for responding to a programmed defective row address that is responsive to the row address of said one of said plurality of rows; and

which programmable inactivation means comprises:

means for blocking the passage of a signal from a decoder unit responsive to an input row address to a control line activating unit ordinarily connected to said decoder unit; and

means for forcing said control line activating unit to a default state that renders said control line inactive; which control line unit includes a low-impedance output directly connected to said control line and being in one of two low-impedance states.

2. A memory according to Claim 1, further characterized in that said means for blocking passage of a signal comprises a fuse adapted for laser-blowing and said means for forcing to a default state comprises a permanently energized transistor having a predetermined impedance and forming a conductive path between a control line activating unit input and a current supply terminal, whereby said control line unit input is connected only to said means for forcing to a default state when said fuse is blown.

3. A memory according to Claim 1, further characterized in that said means for blocking passage of a signal from said decoder unit is located within said decoder unit on a series path of transistors series-connected between a current supply terminal and a switching node, whereby the transformation of said means for blocking passage of a signal from a normally conductive state to a non-conductive state blocks said series path of transistors from switching said switching node from a default state to an active state.

FIG.1

0213044

1/3

ADDRESS BUS

102

ROW #1 DECODER  111

ROW #1  103

ROW #2 DECODER  112

ROW #2  104

ROW #n DECODER

ROW #n

110

NED

SPARE SELECTION DETECTOR  202

SPARE DECODER #1  211

SPARE ROW #1  201

SPARE DECODER #K  212

SPARE ROW #K  202

210

**FIG. 2**

**FIG. 3**

0213044

FIG. 4

(a)

(b)

(c)